(19) Europäisches Patentamt / European Patent Office / Office européen des brevets

(11) **EP 4 481 793 A1**

(12) **DEMANDE DE BREVET EUROPEEN**

(43) Date de publication:
**25.12.2024 Bulletin 2024/52**

(21) Numéro de dépôt: **24181985.3**

(22) Date de dépôt: **13.06.2024**

(51) Classification Internationale des Brevets (IPC):
**H01L 21/033** (2006.01) **H01L 21/311** (2006.01)

(52) Classification Coopérative des Brevets (CPC):
**H01L 21/0337; H01L 21/31144**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **20.06.2023 FR 2306337**

(71) Demandeur: **Commissariat à l'Energie Atomique et aux Energies Alternatives
75015 Paris (FR)**

(72) Inventeurs:
• **PIMENTA BARROS, Patricia
38054 Grenoble Cedex 09 (FR)**
• **FENOUILLET-BERANGER, Claire
38054 Grenoble Cedex 09 (FR)**

(74) Mandataire: **Cabinet Camus Lebkiri
25 rue de Maubeuge
75009 Paris (FR)**

(54) **PROCÉDÉ DE FORMATION DE MOTIFS AYANT DES DIMENSIONS CRITIQUES DIFFÉRENTES**

(57) Un aspect de l'invention concerne un procédé de formation d'un premier groupe de motifs et d'un deuxième groupe de motifs sur une surface d'un substrat, le premier groupe de motifs étant situé dans une première région de la surface du substrat et le deuxième groupe de motifs étant situé dans une deuxième région de la surface du substrat, le procédé comprenant les étapes suivantes :
- formation d'un premier motif sacrificiel et d'un deuxième motif sacrificiel sur le substrat, le premier motif sacrificiel étant situé dans la première région et présentant une première dimension critique, le deuxième motif sacrificiel étant situé dans la deuxième région et présentant une deuxième dimension critique strictement inférieure à la première dimension critique ;
- formation de premiers espaceurs dans la première région, sur des flancs du premier motif sacrificiel, et dans la deuxième région, sur des flancs du deuxième motif sacrificiel ;
- formation d'un deuxième espaceur sur un flanc de chaque premier espaceur situé dans la deuxième région, la formation des deuxièmes espaceurs comprenant notamment une sous-étape de dépôt conforme d'une deuxième couche structurelle dans les première et deuxième régions, la deuxième couche structurelle ayant une épaisseur égale à la différence entre la première dimension critique et la deuxième dimension critique ;
- retrait des premier et deuxième motifs sacrificiels de manière sélective par rapport aux premiers et deuxièmes espaceurs.

Fig. 1

**Description**

## DOMAINE TECHNIQUE DE L'INVENTION

Le domaine technique de l'invention est celui des techniques de lithographie avancées pour l'industrie microélectronique. La présente invention concerne plus particulièrement un procédé de formation de motifs sur un substrat, comprenant notamment la formation d'espaceurs sur les flancs de motifs sacrificiels et le retrait des motifs sacrificiels.

## ARRIERE-PLAN TECHNOLOGIQUE DE L'INVENTION

La technique de structuration double auto-alignée, plus connue sous le sigle « SADP » (pour « Self-Aligned Double Patterning » en anglais), est une technique de lithographie avancée permettant de doubler la densité de motifs obtenus en utilisant un équipement de photolithographie classique, tel qu'un scanner 193 nm à immersion.

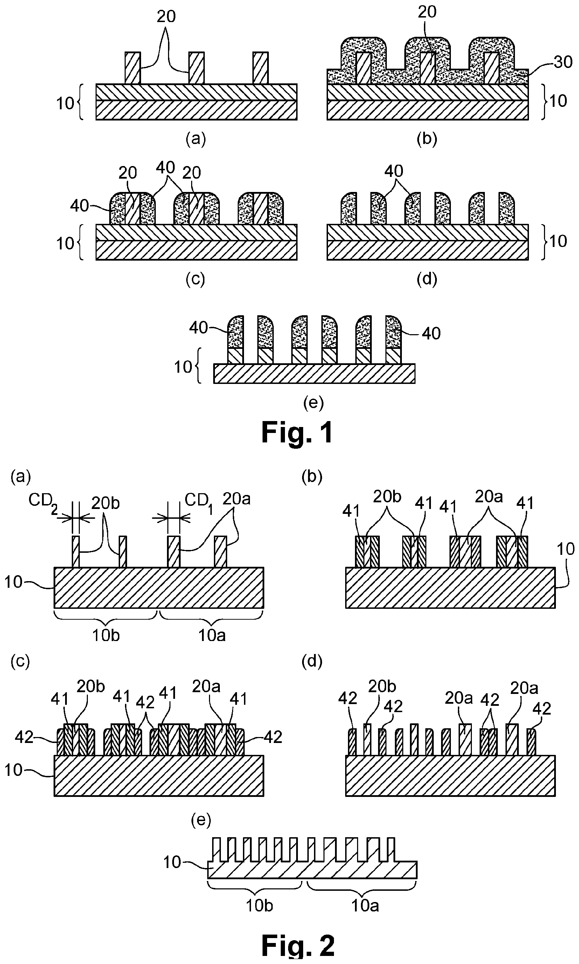

Cette technique comprend cinq étapes, illustrées par la figure 1 :

a) la formation, sur un substrat 10, de motifs sacrificiels 20 appelés « mandrins » ou « guides », typiquement par photolithographie et gravure d'une couche sacrificielle ;

b) le dépôt conforme d'une couche structurelle 30 en un matériau appelé « espaceur » sur le substrat 10 et les motifs sacrificiels 20 ;

c) la gravure anisotrope de la couche structurelle 30, de manière à ne conserver que ses parties verticales, disposées sur les flancs des motifs sacrificiels 20 et formant des espaceurs 40 ;

d) le retrait des motifs sacrificiels 20, sélectivement par rapport aux espaceurs 40 ;

e) le transfert des espaceurs 40 dans une portion superficielle du substrat 10 (typiquement constituée par une couche de masque dur).

Un inconvénient de la technique SADP est que tous les espaceurs 40 formés sur le substrat 10 présentent une même dimension critique CD, définie par l'épaisseur de la couche structurelle 30. Or la fabrication d'un circuit intégré requiert la formation de motifs ayant des dimensions critiques différentes.

Le document [« Analysis of process characteristics of self-aligned multiple patterning », Y. Chen et al., Microelectronic engineering, vol. 98, pp. 184-188, 2012] décrit un procédé permettant de former, simultanément, un premier groupe de motifs ayant une première dimension critique et un deuxième groupe de motifs ayant une deuxième dimension critique différente de la première.

La figure 2 illustre les principales étapes de ce procédé :

a) la formation de premiers mandrins 20a sur une première région 10a d'un substrat 10 et de deuxièmes mandrins 20b sur une deuxième région 10b du substrat 10, les premiers mandrins 20a présentant une dimension critique $CD_1$ supérieure à la dimension critique $CD_2$ des deuxièmes mandrins 20b ;

b) la formation de premiers espaceurs 41, dits espaceurs sacrificiels, sur les flancs des premiers et deuxièmes mandrins 20a-20b ;

c) la formation de deuxièmes espaceurs 42, dits espaceurs structurels, sur les flancs des espaceurs sacrificiels 41 ;

d) le retrait des espaceurs sacrificiels 41, sélectivement par rapport aux mandrins 20a-20b et aux espaceurs structurels 42 ; et

e) le transfert des mandrins 20a-20b et des espaceurs structurels 42 dans une portion superficielle du substrat 10.

La densité des motifs formés initialement dans la deuxième région 10b (les deuxièmes mandrins 20b) est triplée grâce à la double formation d'espaceurs (étapes b) et c)). La deuxième région 10b est pour cette raison qualifiée de région « SATP », pour « Self-Aligned Triple Patterning » en anglais. En revanche, dans la première région 10a, les espaceurs structurels 42 entre deux premiers mandrins 20a sont fusionnés de sorte à obtenir un doublement de la densité des motifs (région dite « SADP »), et non un triplement.

Ce procédé permet donc de former simultanément des motifs de dimensions critiques différentes, selon les régions du substrat. Cependant, il ne permet pas d'obtenir un pas (« pitch » en anglais) entre les motifs de la première région 10a (constitués par les premiers mandrins 20a et les espaceurs structurels 42) identique au pas entre les motifs de la deuxième région 10b (constitués par les deuxièmes mandrins 20b et les espaceurs structurels 42). En outre, les motifs de la première région 10a ne sont pas réguliers en termes de dimension critique, car le premier motif et le dernier motif sont constitués par un unique espaceur structurel 42. Enfin, la fusion des espaceurs structurels 42 est contraignante, car elle oblige à contrôler parfaitement l'espace entre les deux premiers mandrins 20a.

## RESUME DE L'INVENTION

On constate qu'il existe un besoin de prévoir un procédé de formation d'un premier groupe de motifs et d'un deuxième groupe de motifs, les motifs du premier groupe ayant une dimension critique différente de ceux du deuxième groupe, mais un même pas de répétition.

Selon l'invention, on tend à satisfaire ce besoin en prévoyant un procédé de formation d'un premier groupe de motifs et d'un deuxième groupe de motifs sur une surface d'un substrat, le premier groupe de motifs étant situé dans une première région de la surface du substrat et le deuxième groupe de motifs étant situé dans une deuxième région de la surface du substrat, le procédé comprenant les étapes suivantes :

- formation d'un premier motif sacrificiel et d'un deuxième motif sacrificiel sur le substrat, le premier motif sacrificiel étant situé dans la première région et présentant une première dimension critique, le deuxième motif sacrificiel étant situé dans la deuxième région et présentant une deuxième dimension critique strictement inférieure à la première dimension critique ;

- formation de premiers espaceurs dans la première région, sur des flancs du premier motif sacrificiel, et dans la deuxième région, sur des flancs du deuxième motif sacrificiel, la formation des premiers espaceurs comprenant les sous-étapes suivantes :

    - dépôt conforme d'une première couche structurelle dans les première et deuxième régions ;

    - gravure anisotrope de la première couche structurelle ;

- formation d'un deuxième espaceur sur un flanc de chaque premier espaceur situé dans la deuxième région, la formation des deuxièmes espaceurs comprenant les sous-étapes suivantes :

    - dépôt conforme d'une deuxième couche structurelle dans les première et deuxième régions, la deuxième couche structurelle ayant une épaisseur égale à la différence entre la première dimension critique et la deuxième dimension critique ;

    - gravure anisotrope de la deuxième couche structurelle ; et

    - retrait de la deuxième couche structurelle dans la première région ;

- retrait des premier et deuxième motifs sacrificiels de manière sélective par rapport aux premiers et deuxièmes espaceurs.

Ainsi, les motifs du deuxième groupe présentent une dimension critique supérieure à celle des motifs du premier groupe, du fait de la formation des deuxièmes espaceurs contre les premiers espaceurs dans la deuxième région. La différence de dimension critique est générée par une sous-étape de dépôt conforme (de la deuxième couche structurelle), qui est facile à mettre en oeuvre et peut être contrôlée (au nm près) grâce aux techniques de type ALD (« Atomic Layer Déposition » en anglais). Le pas est conservé entre les motifs du premier groupe et ceux du deuxième groupe, grâce au fait que la différence de dimension critique se retrouve entre les premier et deuxième motifs sacrificiels formés initialement.

De préférence, le premier motif sacrificiel sépare deux premières cavités présentant une troisième dimension critique, le deuxième motif sacrificiel sépare deux deuxièmes cavités présentant une quatrième dimension critique et les premiers et deuxièmes espaceurs sont formés sur des parois latérales des premières et deuxièmes cavités.

Avantageusement, la troisième dimension critique et la quatrième dimension critique satisfont les relations suivantes :

$$CD_3 = CD_1 + 2 \times e_1$$

$$CD_4 = CD_2 + 2 \times e_1 + 2 \times e_2$$

où $CD_1$ est la première dimension critique, $e_1$ est l'épaisseur de la première couche structurelle, $CD_2$ est la deuxième dimension critique et $e_2$ est l'épaisseur de la deuxième couche structurelle.

Dans des premier et deuxième modes de mise en oeuvre du procédé, le dépôt conforme de la deuxième couche structurelle est accompli après la gravure anisotrope de la première couche structurelle.

Dans un troisième mode de mise en oeuvre, le dépôt conforme de la deuxième couche structurelle est consécutif au dépôt conforme de la première couche structurelle et la gravure anisotrope de la première couche structurelle est consécutive à la gravure anisotrope de la deuxième couche structurelle.

Outre les caractéristiques qui viennent d'être évoquées dans les paragraphes précédents, le procédé selon l'invention peut présenter une ou plusieurs caractéristiques complémentaires parmi les suivantes, considérées individuellement ou selon toutes les combinaisons techniquement possibles :

- le retrait de la deuxième couche structurelle dans la première région est accompli après la gravure anisotrope de la deuxième couche structurelle ;

- le retrait de la deuxième couche structurelle dans la première région est accompli avant la gravure anisotrope de la deuxième couche structurelle ;

- le retrait des premier et deuxième motifs sacrificiels est accompli après le retrait de la deuxième couche structurelle dans la première région ;

- le retrait des premier et deuxième motifs sacrificiels est accompli entre la gravure anisotrope de la deuxième couche structurelle et le retrait de la deuxième couche structurelle dans la première région ;

- le retrait de la deuxième couche structurelle dans la première région comprend la formation d'un masque de gravure sur la deuxième couche structurelle dans la deuxième région, la gravure de la deuxième couche structurelle à travers le masque de gravure, sélectivement par rapport à la première couche sacrificielle, et le retrait du masque de gravure ;

- la différence entre la première dimension critique et la deuxième dimension critique est supérieure ou égale à 4 nm, de préférence comprise entre 4 nm et 70 nm.

**BREVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente des étapes d'un premier procédé de formation de motifs, connu sous le nom de « SADP » ;

- la figure 2 représente des étapes d'un deuxième procédé de formation de motifs selon l'art antérieur ;

- les figures 3A à 3I représentent en vue de coupe schématique un premier mode de mise en oeuvre du procédé de formation de motifs selon l'invention ;

- les figures 4A à 4I représentent en vue de coupe schématique un deuxième mode de mise en oeuvre du procédé de formation de motifs selon l'invention ; et

- les figures 5A à 5H représentent en vue de coupe schématique un troisième mode de mise en oeuvre du procédé de formation de motifs selon l'invention ; et

- les figures 6A à 6D représentent en vue de coupe schématique un quatrième mode de mise en oeuvre du procédé de formation de motifs selon l'invention.

Pour plus de clarté, les éléments identiques ou similaires sont repérés par des signes de référence identiques sur l'ensemble des figures.

**EP 4 481 793 A1**

## DESCRIPTION DETAILLEE

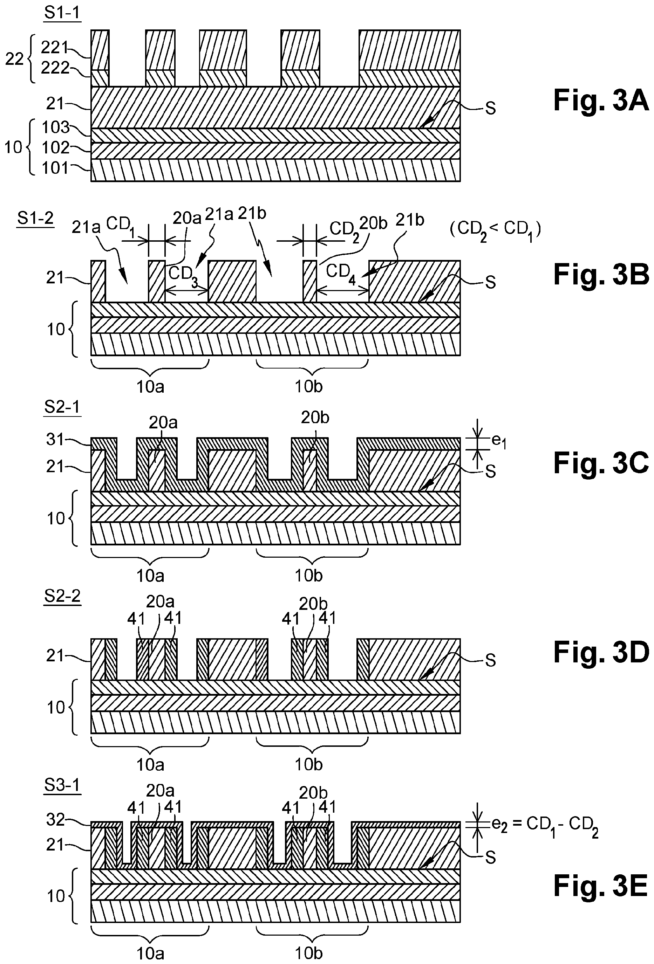

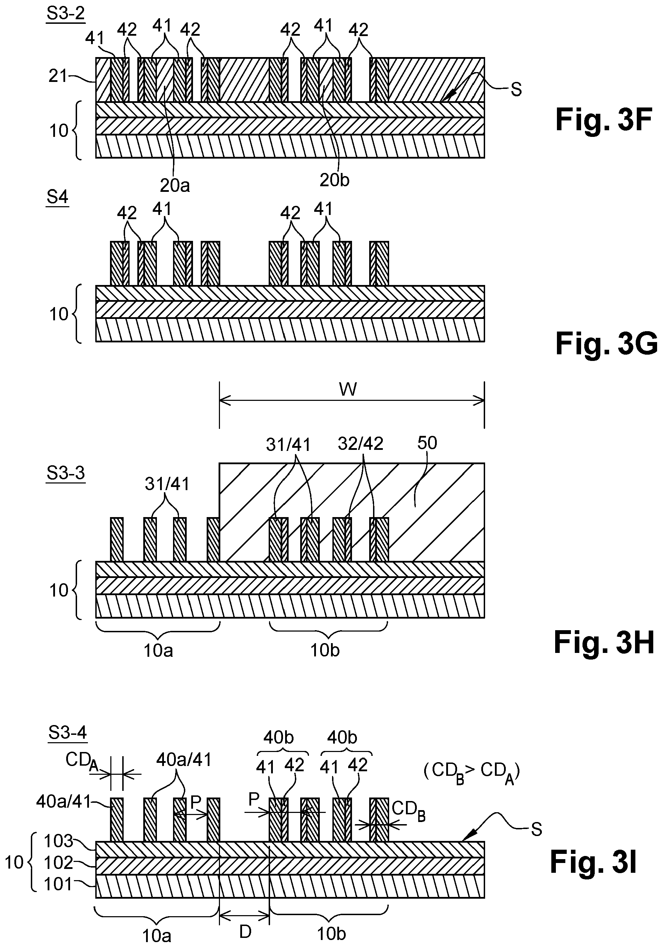

Les figures 3A-3I, 4A-4I et 5A-5H représentent trois modes de mise en oeuvre d'un procédé de formation de motifs sur une surface S d'un substrat 10. En référence aux figures 3I, 4I et 5H, ce procédé permet d'obtenir un premier groupe de motifs 40a dans une première région 10a de la surface S du substrat 10 et un deuxième groupe de motifs 40b dans une deuxième région 10b de la surface S du substrat 10. Les motifs 40a-40b sont des motifs en saillie par rapport à la surface S du substrat 10. Ils ont par exemple la forme de lignes, ces lignes étant de préférence orientées parallèlement les unes aux autres. La surface S du substrat 10 peut être plane ou présenter une topographie (< 40 nm).

Le substrat 10 peut comprendre une couche de support 101, par exemple en un matériau semi-conducteur tel que le silicium, une couche de masque dur 102 disposée sur la couche de support 101 et une couche d'arrêt de gravure 103 disposée sur la couche de masque dur 102. Les motifs 40a-40b sont alors disposés sur la couche d'arrêt de gravure 103, qui forme la surface S du substrat 10.

Chacun des motifs 40a du premier groupe est formé par un espaceur et chacun des motifs 40b du deuxième groupe est formé par deux espaceurs accolés l'un à l'autre. Les espaceurs sont des motifs en saillie formés par paire sur les flancs d'autres motifs topographiques appelés mandrins ou guides.

Les motifs 40a du premier groupe présentent une dimension critique $CD_A$ inférieure à la dimension critique $CD_B$ des motifs 40b du deuxième groupe. On appelle « dimension critique » la plus petite dimension des motifs dans un plan parallèle à la surface S du substrat 10. Ici, la dimension critique des motifs 40a-40b correspond à leur largeur (mesurée dans le plan de coupe des figures). Les dimensions critiques $CD_A$ et $CD_B$ des motifs 40a-40b sont avantageusement inférieures à 40 nm. Par ailleurs, la différence entre la dimension critique $CD_B$ des motifs 40b du deuxième groupe et la dimension critique $CD_A$ des motifs 40a du premier groupe est de préférence supérieure ou égale à 4 nm, avantageusement comprise entre 4 nm et 70 nm.

En revanche, les motifs 40a du premier groupe et les motifs 40b du deuxième groupe présentent un même pas P (« pitch » en anglais), parfois appelé pas de répétition ou pas de réseau. Le pas P est la distance qui sépare les mêmes bords (ou les centres) de deux motifs consécutifs au sein d'un même groupe. Le pas P des motifs 40a-40b est de préférence inférieur à 80 nm.

Un premier mode de mise en oeuvre du procédé de formation va maintenant être décrit, étape par étape, en référence aux figures 3A-3I.

Le procédé de formation comprend tout d'abord une étape S1 visant à former un ou plusieurs premiers motifs sacrificiels 20a (ou mandrins) dans la première région 10a et un ou plusieurs deuxièmes motifs sacrificiels 20b (ou mandrins) dans la deuxième région 10b. Les premiers motifs sacrificiels 20a présentent une première dimension critique $CD_1$ et les deuxièmes motifs sacrificiels 20b présentent une deuxième dimension critique $CD_2$ strictement inférieure à la première dimension critique $CD_1$. La différence entre la première dimension critique $CD_1$ et la deuxième dimension critique $CD_2$ est de préférence supérieure ou égale à 4 nm, avantageusement comprise entre 4 nm et 70 nm.

Dans un souci de simplification, on prendra ci-après l'exemple d'un seul premier motif sacrificiel 20a et d'un seul deuxième motif sacrificiel 20b.

La première étape S1 peut être décomposée en deux sous-étapes S1-1 et S1-2, illustrées respectivement par les figures 3A et 3B, elles-mêmes comprenant plusieurs opérations.

La première sous-étape S1-1 (cf. Fig.3A) comprend le dépôt d'une couche sacrificielle 21 sur la surface S du substrat 10 et la formation d'un premier masque de gravure 22 sur la couche sacrificielle 21. Le matériau de la couche sacrificielle 21 est par exemple du carbone déposé par centrifugation (ou SOC, pour « Spin-On-Carbon » en anglais), du carbone amorphe (a-C), du silicium amorphe (a-Si), une résine, du nitrure de silicium (SiN) ou du dioxyde de silicium ($SiO_2$). L'épaisseur de la couche sacrificielle 21 est de préférence comprise entre 50 nm et 100 nm.

La formation du premier masque de gravure 22 comprend une opération de photolithographie d'une couche de résine 221, et avantageusement, une opération de transfert des motifs photolithographiés dans une couche de masque dur 222 sous-jacente. Un scanner 193 nm à immersion peut être utilisé lors de l'opération de photolithographie. La couche de masque dur 222 est par exemple formée d'un revêtement anti-réfléchissant au silicium (ou SiARC, pour « Silicon containing Anti-Reflective Coating » en anglais) ou d'un revêtement anti-réfléchissant diélectrique (ou DARC, pour « Dielectric Anti-Reflective Coating »). Le SiARC présente l'avantage de pouvoir être déposé par centrifugation (« spin-coating »), comme le SOC (couche sacrificielle 21), alors que le DARC et le carbone amorphe sont généralement déposés par dépôt chimique en phase vapeur assisté par plasma (ou PECVD, pour « Plasma Enhanced Chemical Vapor Déposition » en anglais).

La deuxième sous-étape S1-2 (cf. Fig.3B) comprend la gravure de la couche sacrificielle 21 à travers le premier masque de gravure 22, jusqu'à atteindre la surface S du substrat 10, et le retrait du masque de gravure 22 sélectivement par rapport à la couche sacrificielle 21 et au substrat 10. La gravure de la couche sacrificielle 21 s'arrête de préférence sur la couche d'arrêt de gravure 103, par exemple en nitrure de titane (TiN) ou silicium.

Ainsi, les motifs photolithographiés dans la couche de résine 221 sont transférés dans la couche sacrificielle 21 et forment les motifs sacrificiels 20a-20b. Les dimensions critiques des motifs photolithographiés (Fig.3A) peuvent être conservées ou réduites lors du transfert, afin d'atteindre les valeurs souhaitées de dimensions critiques pour le premier motif sacrificiel 20a ($CD_1$) et pour le deuxième motif sacrificiel 20b ($CD_2$).

Le procédé comprend ensuite une étape S2 de formation de premiers espaceurs 41 dans la première région 10a, sur les flancs (ou parois latérales) du premier motif sacrificiel 20a, et de premiers espaceurs 41 dans la deuxième région 10b, sur les flancs du deuxième motif sacrificiel 20b.

La formation des premiers espaceurs 41 comprend deux sous-étapes S2-1 et S2-2, illustrées respectivement par les figures 3C et 3D.

La première sous-étape S2-1 (cf. Fig.3C) consiste à déposer de manière conforme une première couche 31 dite structurelle dans les première et deuxième régions 10a-10b, de manière à recouvrir entièrement le premier motif sacrificiel 20a et le deuxième motif sacrificiel 20b (autrement dit, les flancs et la face supérieure des motifs sacrificiels 20a-20b). La première couche 31 est qualifiée de « structurelle » car elle sert à former une partie au moins des motifs 40a-40b finaux, par opposition à une couche dite « sacrificielle » qui est vouée à disparaître totalement avant la fin du procédé.

La première couche structurelle 31 est ainsi d'épaisseur $e_1$ constante et épouse le relief formé à la surface S du substrat 10. L'épaisseur $e_1$ de la première couche structurelle 31 est de préférence comprise entre 10 nm et 36 nm, par exemple égale à 20 nm. Le matériau de la première couche structurelle 31 peut être du dioxyde de silicium ($SiO_2$) ou du nitrure de silicium (SiN).

La première couche structurelle 31 est de préférence déposée sur toute la surface S du substrat 10 (dépôt dit « pleine plaque »). La technique de dépôt conforme employée pour former la première couche structurelle 31 est par exemple le dépôt en couches atomiques (ou ALD, pour « Atomic Layer Déposition » en anglais), éventuellement assisté par plasma (PEALD, « Plasma Enhanced Atomic Layer Déposition »), ou le dépôt chimique en phase vapeur assisté par plasma (PECVD). La température maximale de dépôt dépend notamment du matériau choisi pour former les motifs sacrificiels 20a-20b (matériau de la couche sacrificielle 21). Par exemple, certains SOC imposent une température maximale de dépôt d'environ 275 °C, alors que le carbone amorphe (déposé par PECVD) et le silicium amorphe (déposé par PECVD, voire LPCVD) supportent des températures plus élevées.

Lors de la deuxième sous-étape S2-2 (cf. Fig.3D), la première couche structurelle 31 est gravée de manière anisotrope, selon une direction préférentielle de gravure perpendiculaire à la surface S du substrat 10 (ou au plan dans lequel s'étend le substrat). Cette étape de gravure anisotrope permet d'éliminer uniquement les parties horizontales de la première couche structurelle 31, disposées sur la surface S du substrat 10 et sur les faces supérieures des motifs sacrificiels 20a-20b. Les parties verticales de la première couche structurelle 31, disposées contre les flancs des motifs sacrificiels 20a-20b, sont conservées et constituent les premiers espaceurs 41.

Le procédé comprend ensuite une étape S3 de formation d'un deuxième espaceur 42 sur un flanc de chaque premier espaceur 41 situé dans la deuxième région 10b uniquement. Cette étape peut être décomposée en quatre sous-étapes S3-1 à S3-4 illustrées par les figures 3E-3F et 3H-3I.

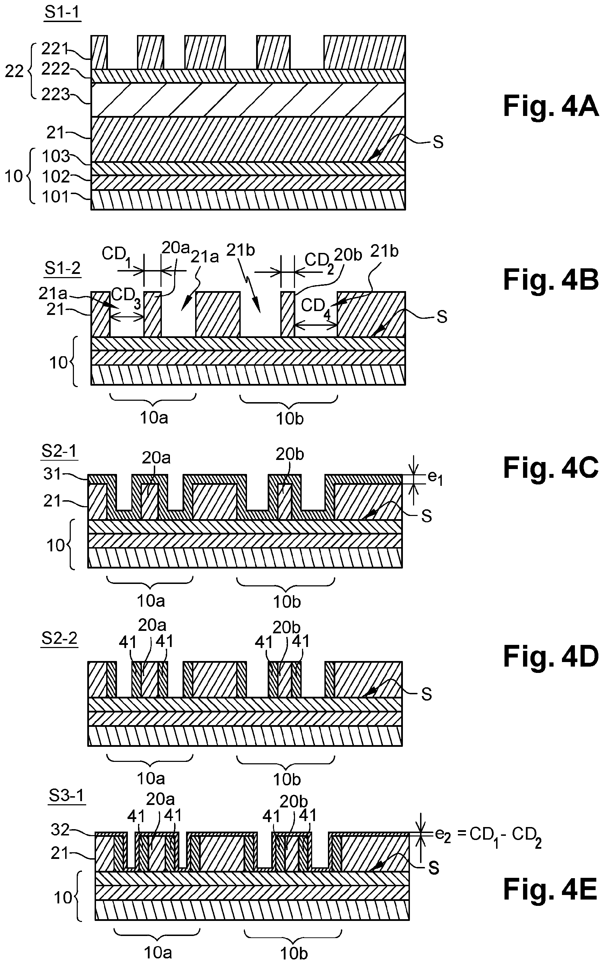

Dans ce premier mode de mise en oeuvre (comme dans le deuxième mode de mise en oeuvre décrit ci-après en relation avec les figures 4A-4I), les deuxièmes espaceurs 42 sont d'abord formés dans les deux régions 10a-10b (sous-étapes S3-1 et S3-2), puis les deuxièmes espaceurs 42 situés dans la première région 10a sont éliminés (sous-étapes S3-3 et S3-4), pour ne conserver que les deuxièmes espaceurs 42 situés dans la deuxième région 10b.

Les deuxièmes espaceurs 42 sont formés de la même manière que les premiers espaceurs 41 (décrite en relation avec les figures 3C-3D), en deux sous-étapes S3-1 et S3-2 illustrées respectivement par la figure 3E et la figure 3F :

- S3-1 : dépôt conforme d'une deuxième couche structurelle 32 dans les première et deuxième régions 10a-10b (par exemple par ALD, PEALD ou PECVD), en recouvrant ici entièrement les motifs sacrificiels 20a-20b et les premiers espaceurs 41 ; puis
- S3-2 : gravure anisotrope de la deuxième couche structurelle 32, selon une direction préférentielle de gravure perpendiculaire à la surface S du substrat 10 (ou au plan du substrat 10).

L'épaisseur $e_2$ de la deuxième couche structurelle 32 est constante et égale à la différence entre la première dimension critique $CD_1$ (premier motif sacrificiel 20a) et la deuxième dimension critique $CD_2$ (deuxième motif sacrificiel 20b), soit :

[Math. 1]

$$e_2 = CD_1 - CD_2$$

L'épaisseur $e_2$ de la deuxième couche structurelle 32 est donc préférentiellement supérieure ou égale à 4 nm, avantageusement comprise entre 4 nm et 70 nm.

Le matériau de la deuxième couche structurelle 32 peut être du dioxyde de silicium (SiO$_2$), du nitrure de silicium (SiN), de l'oxyde d'aluminium (Al$_2$O$_3$) ou du dioxyde de titane (TiO$_2$). Il est choisi de manière à pouvoir être gravé sélectivement par rapport au matériau de la première couche structurelle 31 (et par rapport au substrat 10).

Lors de la troisième sous-étape S3-3 représentée par la figure 3H, un deuxième masque de gravure 50 est formé dans la deuxième région 10b (ou en dehors de la première région 10a), de manière à protéger les premiers et deuxièmes espaceurs 41-42 situés dans cette deuxième région 10b. Puis, les deuxièmes espaceurs 42 situés dans la première région 10a sont gravés à travers le deuxième masque de gravure 50 sélectivement par rapport aux premiers espaceurs 41 (et par rapport au substrat 10).

Le deuxième masque de gravure 50 est par exemple formé d'un empilement bicouches comprenant une couche de résine photosensible disposée sur un revêtement anti-réfléchissant inférieur (ou BARC, pour « Bottom Anti-Reflective Coating ») (résine / BARC), voire d'une seule couche de résine lorsque les dimensions le permettent (distance entre les groupes de motifs notamment).

Les première et deuxième régions 10a-10b de la surface S ayant des dimensions bien supérieures aux dimensions critiques des motifs 40a-40b à former, ou même des motifs sacrificiels 20a-20b, la formation du deuxième masque de gravure 50 peut comprendre une opération de photolithographie classique, par exemple en utilisant un scanner 193 nm à immersion. Autrement dit, cette deuxième opération de photolithographie est relâchée en termes de dimensionnement. Typiquement, la zone couverte par le deuxième masque de gravure 50 peut présenter une largeur W comprise entre 100 nm et 100 $\mu$m, par exemple égale à 1 $\mu$m.

Enfin, en référence à la figure 3I, le deuxième masque de gravure 50 est retiré (sélectivement par rapport aux espaceurs 41-42 et au substrat 10) lors de la sous-étape S3-4.

Autrement dit, les sous-étapes S3-3 et S3-4 des figures 3H et 3I permettent de retirer de la première région 10a la deuxième couche structurelle 32, ici structurée sous la forme des deuxièmes espaceurs 42, sélectivement par rapport à la première couche structurelle 31, elle-même structurée sous la forme des premiers espaceurs 41.

Un procédé de gravure isotrope est avantageusement utilisé pour graver de manière sélective la deuxième couche structurelle 32 (ou les deuxièmes espaceurs 42) dans la première région 10a. Des exemples de procédé de gravure isotrope sont donnés ci-après, suivant les matériaux des première et deuxième couches structurelles 31-32.

Entre la sous-étape S3-2 de gravure anisotrope de la deuxième couche structurelle 32 et les sous-étapes S3-3 et S3-4 de retrait de la deuxième couche structurelle 32 dans la première région 10a, le procédé de formation selon le premier mode de mise en oeuvre comprend une étape S4 de retrait des premier et deuxième motifs sacrificiels 20-20b, sélectivement par rapport aux premiers et deuxièmes espaceurs 41-42 et au substrat 10 (cf. Fig.3G). A nouveau, un procédé de gravure isotrope (et sélectif) est avantageusement utilisé. On peut citer à titre d'exemple une gravure plasma à base d'O$_2$ ou H$_2$ (N$_2$/H$_2$, O$_2$/N$_2$, O$_2$, SO$_2$/O$_2$...) dans le cas d'un matériau carboné (ex. a-C, SOC), et dans le cas d'un silicium amorphe, une gravure humide (par exemple hydroxyde de tétraméthylammonium (TMAH)) ou une gravure plasma à base d'HBr ou de Cl$_2$ (HBr/O$_2$ ou HBr/Cl$_2$/O$_2$, NF3/Hbr... ).

Ainsi, à l'issue du procédé de formation (cf. Fig.3I), les motifs 40a du premier groupe (dans la première région 10a) sont formés par les premiers espaceurs 41. Leur dimension critique CD$_A$ est égale à l'épaisseur e$_1$ de la première couche structurelle 31.

[Math. 2]

$$CD_A = e_1$$

Les motifs 40b du deuxième groupe (dans la deuxième région 10b) sont formés chacun par la juxtaposition d'un premier espaceur 41 et d'un deuxième espaceur 42. Leur dimension critique CD$_B$ est égale à la somme de l'épaisseur e$_1$ de la première couche structurelle 31 et de l'épaisseur e$_2$ de la deuxième couche structurelle 32.

[Math. 3]

$$CD_B = e_1 + e_2$$

Le pas P des motifs 40a du premier groupe est égal à la somme de leur dimension critique CD$_A$ et de la dimension critique CD$_1$ du premier motif sacrificiel 20a, mais aussi à la somme entre l'épaisseur e$_1$ de la première couche structurelle 31, l'épaisseur e$_2$ de la deuxième couche structurelle 32 et la dimension critique CD$_2$ du deuxième motif sacrificiel 20b (cf. relation [Math. 1]), et donc au pas des motifs 40b du deuxième groupe.

[Math. 4]

$$P = CD_A + CD_1 = e_1 + CD_1 = e_1 + e_2 + CD_2 = CD_B + CD_2$$

Il existe de nombreuses combinaisons de matériaux et de techniques (de dépôt, gravure...) pour mettre en oeuvre les étapes S1 à S4 du procédé des figures 3A à 3I. Selon un premier exemple, la couche sacrificielle 21 (formant les motifs sacrificiels 20a-20b) est en un matériau carboné (ex. a-C, SOC), la première couche structurelle 31 (formant les premiers espaceurs 41) est en $SiO_2$ (peut être déposé par PEALD), la deuxième couche structurelle 32 (formant les deuxièmes espaceurs 42) est en $Al_2O_3$ ou $TiO_2$ (peut être déposé par ALD) et la couche d'arrêt de gravure 103 du substrat 10 est en silicium. La deuxième couche structurelle 32 est gravée (dans la première région 10a) de manière isotrope et sélective par rapport à la première couche structurelle 31 (lors de la sous-étape S3-3 de la figure 3H) au moyen d'un plasma $BCl_3/Cl_2$. Selon un deuxième exemple, la couche sacrificielle 21 est en un matériau carboné, la première couche structurelle 31 est en $SiO_2$, la deuxième couche structurelle 32 est en SiN et la couche d'arrêt de gravure 103 du substrat 10 est en TiN. La deuxième couche structurelle 32 est gravée (dans la première région 10a) de manière isotrope et sélective par rapport à la première couche structurelle 31 au moyen d'un plasma contenant du fluor (ex. $SF_6$/Hbr, $NF_3$/Hbr ou $CH_3F/O_2$/He) sans bombardement ionique.

Les figures 4A à 4I représentent un deuxième mode de mise en oeuvre du procédé de formation de motifs.

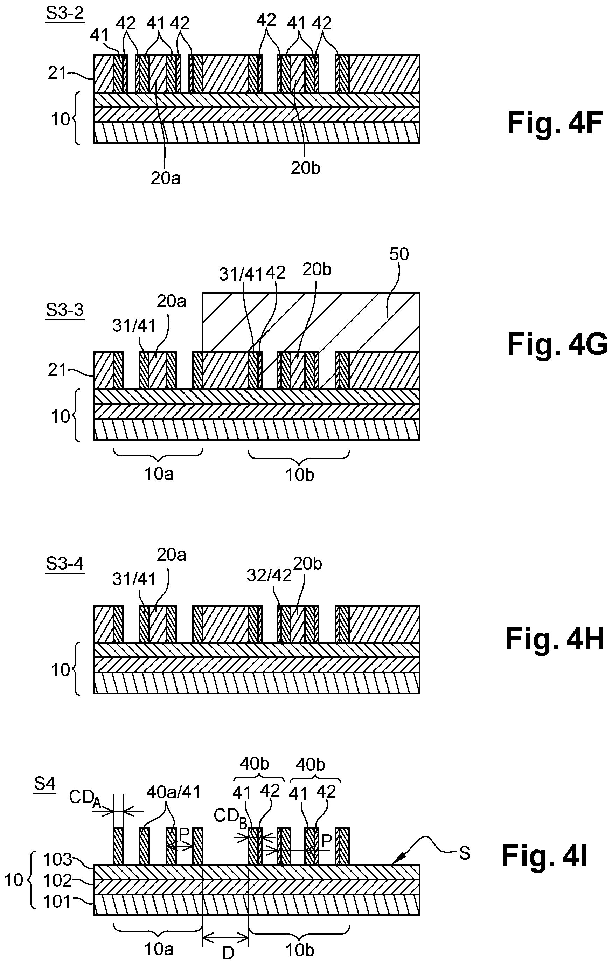

Ce deuxième mode de mise en oeuvre diffère du premier mode de mise en oeuvre en ce que l'étape S4 de retrait des motifs sacrificiels 20a-20b (cf. Fig.4I) est accomplie après les sous-étapes S3-3 et S3-4 de retrait de la deuxième couche structurelle 32 (structurée sous la forme des deuxièmes espaceurs 42) dans la première région 10a (Fig.4G et Fig.4H). Autrement dit, les motifs sacrificiels 20a-20b sont retirés à la fin du procédé de formation de motifs.

Cette chronologie procure deux avantages. Premièrement, le motif sacrificiel 20a rend les premiers espaceurs 41 plus stables mécaniquement, lors de la gravure des deuxièmes espaceurs 42 situés dans la première région 10a (sous-étape S3-3 de la figure 4G), ce qui permet de choisir une gravure humide sans risque d'effondrement des premiers espaceurs 41 (ce risque étant par exemple lié à des forces de capillarité). Deuxièmement, la formation du deuxième masque de gravure 50 est plus facile, car l'espace à combler est plus faible en présence du deuxième motif sacrificiel 20b.

En outre, dans ce deuxième mode de mise en oeuvre, la couche sacrificielle 21 (et donc les motifs sacrificiels 20a-20b) est avantageusement en un matériau inorganique, tel que le silicium amorphe. Ainsi, lors de la formation du deuxième masque de gravure 50 (sous-étape S3-3 de la figure 4G), l'empilement résine/BARC (ou la couche de résine seule) peut être retiré dans la première zone 10a sans endommager le premier motif sacrificiel 20a.

Le premier masque de gravure 22 utilisé pour délimiter les motifs sacrificiels 20a-20b (étape S1-1 de la figure 4A) peut dans ce cas comporter, outre la couche de résine 221 et la couche de masque dur 222 (ex. SiARC), une couche de SOC 223 disposée entre la couche sacrificielle 21 et la couche de masque dur 222.

Dans le cas d'une couche sacrificielle 21 en silicium amorphe, la couche d'arrêt de gravure 103 du substrat 10 est de préférence en TiN.

Au-delà de ces différences, l'étape S1 de formation des motifs sacrificiels 20a-20b (Fig.4A et Fig.4B), l'étape S2 de formation des premiers espaceurs 41 (Fig.4C et Fig.4D), l'étape S3 de formation des deuxièmes espaceurs 42 dans la première région 10a (Fig.4E, Fig.4F, Fig.4G et Fig.4H) et l'étape S4 de retrait des motifs sacrificiels 20a-20b (Fig.4I) sont accomplies de la manière décrite en relation avec les figures 3A-3I.

Il existe de nombreuses combinaisons de matériaux et de techniques (de dépôt, gravure...) pour mettre en oeuvre les étapes S1 à S4 du procédé des figures 4A à 4I. Selon un premier exemple, la couche sacrificielle 21 (formant les motifs sacrificiels 20a-20b) est en silicium amorphe, la première couche structurelle 31 (formant les premiers espaceurs 41) est en SiN (résistant à l'acide fluorhydrique, HF), la deuxième couche structurelle 32 (formant les deuxièmes espaceurs 42) est en $SiO_2$ (peut être déposé par PEALD ou ALD à basse température) et la couche d'arrêt de gravure 103 du substrat 10 est en TiN. Une gravure humide à base de HF est accomplie pour éliminer la deuxième couche structurelle 32 dans la première région 10a (sous-étape S3-3 de la figure 4G). Selon un deuxième exemple, la couche sacrificielle 21 est en silicium amorphe, la première couche structurelle 31 est en $SiO_2$, la deuxième couche structurelle 32 est en SiN et la couche d'arrêt de gravure 103 du substrat 10 est en TiN. La deuxième couche structurelle 32 est gravée (dans la première région 10a) de manière isotrope et sélective par rapport à la première couche structurelle 31 au moyen d'un plasma contenant du fluor (ex. $SF_6$/Hbr ou $CH_3F/O_2$/He) sans bombardement ionique.

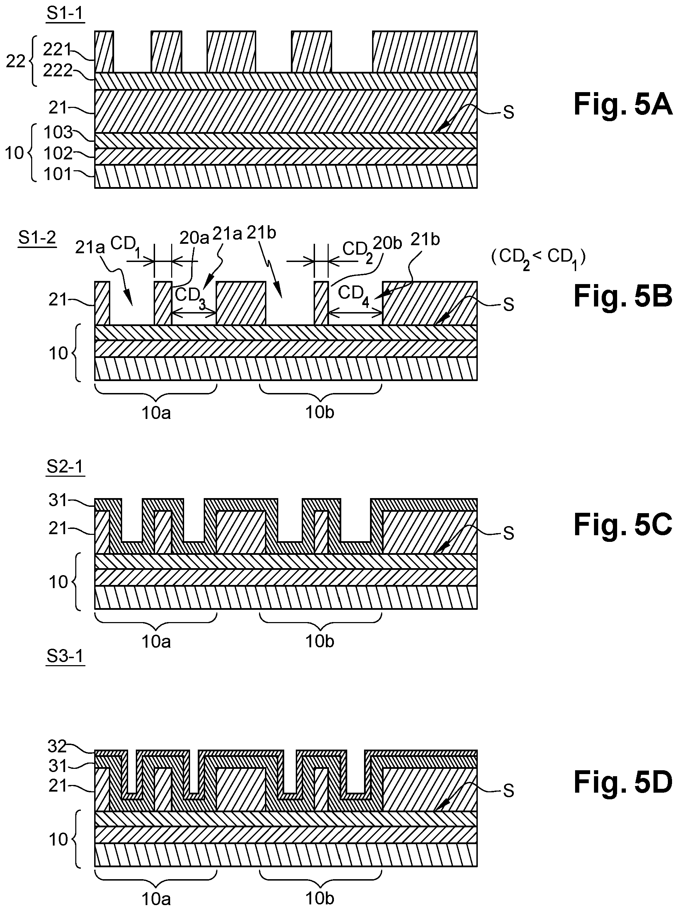

Les figures 5A à 5H représentent un troisième mode de mise en oeuvre du procédé de formation de motifs, qui se distingue des deux précédents par une autre chronologie dans les étapes et sous-étapes de fabrication.

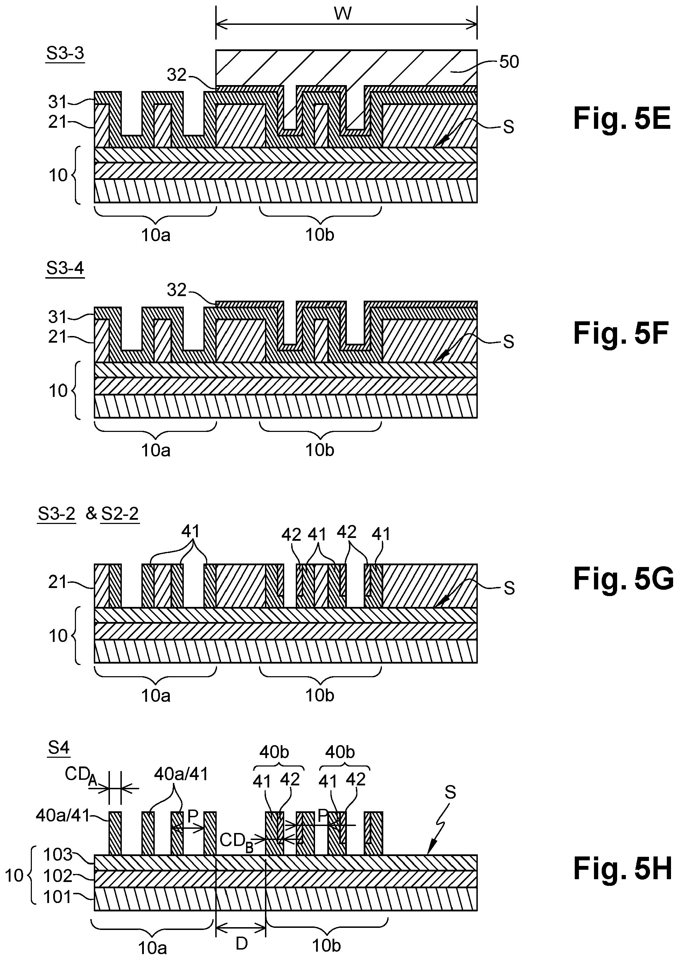

Ainsi, dans ce troisième mode de mise en oeuvre, le dépôt conforme de la deuxième couche structurelle 32 (sous-étape S3-1 représentée par la figure 5D) est consécutif au dépôt conforme de la première couche structurelle 31 (sous-étape S2-1 représentée par la figure 5C) et la gravure anisotrope de la première couche structurelle 31 (sous-étape S2-2) est consécutive à la gravure anisotrope de la deuxième couche structurelle 32 (sous-étape S3-2, cf. Fig.5G).

Autrement dit, les deux couches structurelles 31-32 sont déposées l'une sur l'autre, avantageusement en utilisant la même technique de dépôt conforme (PEALD, ALD et PECVD) (Fig.5D), puis gravées l'une après l'autre pour délimiter les premiers et deuxièmes espaceurs 41-42, de préférence en utilisant un même procédé de gravure, par exemple une gravure plasma à base de fluor (ex. $CH_2F_2$/He/$CF_4$ ou $CF_4$/Ar) avec du bombardement ionique (Fig.5G).

Par ailleurs, les sous-étapes S3-3 et S3-4 de l'étape S3 (cf. Fig.5E et Fig.5F), permettant de retirer la deuxième couche structurelle 32 dans la première région 10a, sont accomplies avant la gravure anisotrope de la deuxième couche structurelle 32 (Fig.5G). Autrement dit, le masque de gravure 50 est formé sur les première et deuxième couches structurelles 31-32 avant qu'elles ne soient structurées sous la forme des premiers espaceurs 41 et deuxièmes espaceurs 42 respectivement. De même, la deuxième couche structurelle 32 est retirée dans la première zone 10a, sélectivement par rapport à la première couche structurelle 31, avant qu'elle ne soit structurée sous la forme des deuxièmes espaceurs 42.

Le retrait des motifs sacrificiels 20a-20b (étape S4 de la figure 5H) est accompli après les sous-étapes de gravure anisotrope S3-2 et S2-2, donc après le retrait de la deuxième couche structurelle 32 dans la première région 10a (sous-étapes S3-3 et S3-4 des figures 5E-5F), comme dans le deuxième mode de mise en oeuvre.

Ce troisième mode de mise en oeuvre est le plus simple à mettre en oeuvre, car les deux étapes de dépôt conforme sont consécutives et les deux étapes de gravure anisotrope sont également consécutives. En revanche, il y a un risque d'un moins bon contrôle de la dimension critique des espaceurs, car l'épaisseur des couches à graver de manière anisotrope varie entre les deux régions 10a-10b. Plus précisément, dans la première région 10a, on élimine les portions horizontales de la première couche structurelle, d'épaisseur $e_1$, alors que dans la deuxième région 10b, on élimine les portions horizontales de la première couche structurelle 31 et de la deuxième couche structurelle 32, soit le cumul des épaisseurs $e_1$ et $e_2$.

L'étape S1 de formation des motifs sacrificiels 20a-20b (Fig.5A et Fig.5B) peut être accomplie de la manière décrite en relation avec les figures 3A-3B.

Il existe de nombreuses combinaisons de matériaux et de techniques (de dépôt, gravure...) pour mettre en oeuvre les étapes S1 à S4 du procédé des figures 5A à 5H. Selon un premier exemple, la couche sacrificielle 21 est en un matériau carboné ou en silicium amorphe, la première couche structurelle 31 est en $SiO_2$, la deuxième couche structurelle 32 est en SiN (peut être déposé par PEALD ou ALD) et la couche d'arrêt de gravure 103 du substrat 10 est en TiN. Une gravure au moyen d'un plasma contenant du fluor (ex. SF6/Hbr ou $CH_3F$/$O_2$/He) sans bombardement ionique est accomplie pour éliminer la deuxième couche structurelle 32 dans la première région 10a (sous-étape S3-3 de la figure 5E). Selon un deuxième exemple, la couche sacrificielle 21 est en un matériau carboné ou en silicium amorphe, la première couche structurelle 31 est en SiN (résistant à l'acide fluorhydrique, HF), la deuxième couche structurelle 32 est en $SiO_2$ (peut être déposé par PEALD ou ALD à basse température) et la couche d'arrêt de gravure 103 du substrat 10 est en TiN. Une gravure humide à base de HF est accomplie pour éliminer la deuxième couche structurelle 32 dans la première région 10a.

Le procédé décrit ci-dessus en relation avec les figures 3A-3I, 4A-4I et 5A-5H permet d'obtenir facilement des motifs 40a-40b ayant une faible différence de dimension critique, typiquement supérieure ou égale à 4 nm, car cette différence de dimension critique correspond à l'épaisseur d'un dépôt conforme, une étape de fabrication qui est bien maitrisée dans l'industrie microélectronique. En outre, les motifs obtenus sont symétriques en termes de pas et de dimension critique, contrairement à ceux obtenus avec le procédé de l'art antérieur (Fig.2 ; région SADP).

Les motifs 40a-40b formés sur la surface S du substrat 10 peuvent être ensuite transférés dans le substrat 10, pour former un niveau de circuit intégré, par exemple les grilles de transistors ou des lignes d'interconnexion. Dans l'exemple d'intégration décrit ci-dessus, les motifs 40a-40b sont d'abord transférés dans la couche d'arrêt de gravure 103, puis dans la couche de masque dur 102, et enfin dans la couche de support 101.

Les deux groupes de motifs sont avantageusement espacés d'une distance D supérieure ou égale à la première dimension critique $CD_1$, de préférence comprise entre 44 nm et 10 $\mu$m, par exemple égale à 300 nm.

Comme cela est illustré sur les figures, le premier motif sacrificiel 20a peut séparer deux premières cavités 21a présentant une troisième dimension critique $CD_3$ et le deuxième motif sacrificiel 20b peut séparer deux deuxièmes cavités 21b présentant une quatrième dimension critique $CD_4$.

Ces cavités 21a-21b sont formés en gravant la couche sacrificielle 21 lors de la deuxième sous-étape S1-2 de l'étape S1 de formation des motifs sacrificiels 20A-20b.

Elles permettent de former deux autres premiers espaceurs 41 et deux autres deuxièmes espaceurs 42 dans chaque région 10a, 10b de la surface S du substrat 10, sur des parois latérales des cavités 21a-21b situées en regard des flancs des motifs sacrificiels 20a, 20b, et donc d'augmenter (de 2 à 4) le nombre de motifs 40a, 40b dans chaque groupe. Les flancs des motifs sacrificiels 20a, 20b constituent également des parois latérales des cavités 21a-21b.

Pour cela, le dépôt conforme de la première couche structurelle 31 est accompli de sorte qu'elle recouvre le fond et les parois latérales des cavités 21a-21b (mais sans les remplir entièrement) et le dépôt conforme de la deuxième couche structurelle 32 est accompli de sorte qu'elle recouvre le fond et les parois latérales des cavités 21a-21b (mais sans les remplir entièrement).

Pour que le pas P des motifs 40a, 40b soit constant, la troisième dimension critique $CD_3$ et la quatrième dimension critique $CD_4$ satisfont les relations suivantes :

[Math. 5]

$$CD_3 = CD_1 + 2 \times e_1$$

où $CD_1$ est la première dimension critique (premier motif sacrificiel 20a) et $e_1$ est l'épaisseur de première couche structurelle 31 ; et

[Math. 6]

$$CD_4 = CD_2 + 2 \times e_1 + 2 \times e_2$$

où $CD_2$ est la deuxième dimension critique (deuxième motif sacrificiel 20b), $e_1$ est l'épaisseur de première couche structurelle 31 et $e_2$ est l'épaisseur de deuxième couche structurelle 32.

Chaque région 10a, 10b peut contenir plusieurs motifs sacrificiels 20a, 20b de même dimension critique $CD_1$, $CD_2$ (et séparés deux à deux par une cavité 21a, 21b) afin d'obtenir un nombre de motifs supérieur à 4 dans le groupe correspondant.

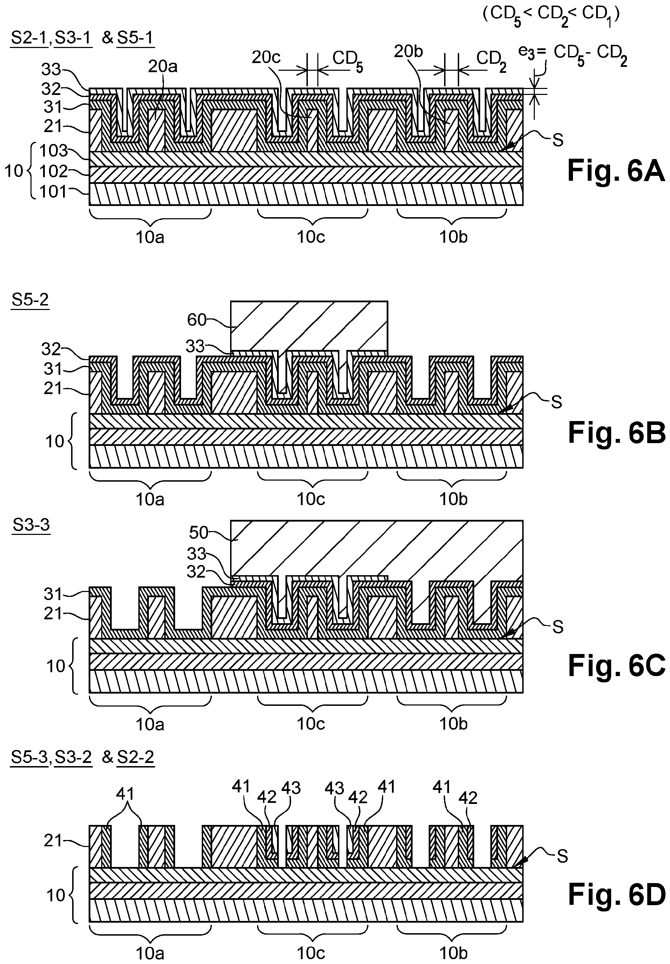

Le procédé de formation de motifs peut être étendu à plus de deux groupes de motifs. Les figures 6A à 6D représentent un mode de mise en oeuvre du procédé pour former trois groupes de motifs (de dimensions critiques différentes mais présentant un même pas de répétition).

Au moins un troisième motif sacrificiel 20c est formé dans une troisième région 10c du substrat 10, de préférence en même temps que les premier et deuxième motifs sacrificiels 20a-20b (et de la façon décrite ci-dessus). Ce troisième motif sacrificiel 20c présente une dimension critique $CD_5$ strictement inférieure à la (deuxième) dimension critique $CD_2$ du deuxième motif sacrificiel 20b. La différence entre la dimension critique $CD_5$ du troisième motif sacrificiel 20c et la dimension critique $CD_2$ du deuxième motif sacrificiel 20b est de préférence supérieure ou égale à 4 nm, avantageusement comprise entre 4 nm et 70 nm.

En plus des étapes S1-S4 décrites précédemment, le procédé de formation comprend une étape S5 de formation d'un troisième espaceur 43 sur un flanc de chaque deuxième espaceur 42 situé dans la troisième région 10c, d'où il résulte que chaque motif de la troisième région 10c est formé par la juxtaposition d'un premier espaceur 41, d'un deuxième espaceur 42 et d'un troisième espaceur 43.

La formation des troisièmes espaceurs 43 comprend les sous-étapes de :

- S5-1 : dépôt conforme d'une troisième couche structurelle 33 dans les première, deuxième et troisième régions 10a-10c, la troisième couche structurelle 43 ayant une épaisseur $e_3$ égale à la différence entre la deuxième dimension critique $CD_2$ du deuxième motif sacrificiel 20b et la dimension critique $CD_5$ du troisième motif sacrificiel 20c (cf. Fig.6A) ;

- S5-2 : retrait de la troisième couche structurelle 33 dans les première et deuxième régions 10a-10b (cf. Fig.6B) ; et

- S5-3 : gravure anisotrope de la troisième couche structurelle 33 (selon une direction préférentielle perpendiculaire à la surface S du substrat) (cf. Fig.6D).

Le dépôt conforme de la troisième couche structurelle 33 (sous-étape S5-1 ; cf. Fig.6A) peut être consécutif au dépôt conforme de la deuxième couche structurelle 32 (sous-étape S3-1), lui-même consécutif au dépôt conforme de la première couche structurelle 31 (sous-étape S2-1), de sorte que la troisième couche structurelle 33 est déposée sur les première et deuxième couches structurelles 31-32 avant leur gravure sous forme d'espaceurs.

Le retrait localisé de la troisième couche structurelle 33 comprend de préférence :

- la formation d'un troisième masque de gravure 60 (ex. résine/BARC) dans la troisième région 10c (ou en dehors des première et deuxième régions 10a-10b), de manière à protéger les portions de première, deuxième et troisième couches structurelle 31-33 situées dans cette troisième région 10c ;

- la gravure de la troisième couche structurelle 33 à travers le troisième masque de gravure 60, sélectivement par rapport à la deuxième couche structurelle 32 et, de préférence, de manière isotrope ; et

- le retrait du troisième masque de gravure 60 (sélectivement par rapport à la deuxième couche structurelle 32 et la troisième couche structurelle 33).

Outre la deuxième région 10b, le deuxième masque de gravure 50 recouvre la troisième région 10c, de façon à conserver la deuxième couche structurelle 32 également dans la troisième région 10c lors du retrait de la deuxième couche structurelle 32 de la première région 10a (sous-étape S3-3 de la figure 6C).

Les gravures anisotropes de la troisième couche structurelle 33 (sous-étape S5-3), de la deuxième couche structurelle 32 (sous-étape S3-2) et de la première couche structurelle 31 (sous-étape S2-2) peuvent se succéder dans cet ordre (cf. Fig.6D). Elles sont de préférence accomplies en utilisant un même procédé de gravure.

Dans une variante de mise en oeuvre, la troisième couche structurelle 33 est déposée de manière conforme (sous-étape S5-1) et retirée des première et deuxième régions 10a-10b (sous-étape S5-2) avant que la deuxième couche structurelle 32 ne soit déposée (sous-étape S3-1) et retirée de la première région 10a (sous-étapes S3-3 et S3-4).

De nombreuses variantes et modifications du procédé de formation de motifs apparaitront à l'homme du métier. Les motifs formés peuvent adopter d'autres géométries que des lignes parallèles. Les motifs peuvent notamment être des anneaux (ou cylindres éventrés) ou des lignes perpendiculaires entre elles.

## Revendications

1. Procédé de formation d'un premier groupe de motifs (40a) et d'un deuxième groupe de motifs (40b) sur une surface (S) d'un substrat (10), le premier groupe de motifs (40a) étant situé dans une première région (10a) de la surface du substrat et le deuxième groupe de motifs (40b) étant situé dans une deuxième région (10b) de la surface du substrat, le procédé comprenant les étapes suivantes :

   - formation (S1) d'un premier motif sacrificiel (20a) et d'un deuxième motif sacrificiel (20b) sur le substrat (10), le premier motif sacrificiel (20a) étant situé dans la première région (10a) et présentant une première dimension critique ($CD_1$), le deuxième motif sacrificiel (20b) étant situé dans la deuxième région (10b) et présentant une deuxième dimension critique ($CD_2$) strictement inférieure à la première dimension critique ($CD_1$) ;
   - formation (S2) de premiers espaceurs (41) dans la première région (10a), sur des flancs du premier motif sacrificiel (20a), et dans la deuxième région (10b), sur des flancs du deuxième motif sacrificiel (20b), la formation des premiers espaceurs (41) comprenant les sous-étapes suivantes :

     ◦ dépôt conforme (S2-1) d'une première couche structurelle (31) dans les première et deuxième régions (10a-10b) ;
     ◦ gravure anisotrope (S2-2) de la première couche structurelle (31) ;

   - formation (S3) d'un deuxième espaceur (42) sur un flanc de chaque premier espaceur (41) situé dans la deuxième région (10b), la formation des deuxièmes espaceurs (42) comprenant les sous-étapes suivantes :

     ◦ dépôt conforme (S3-1) d'une deuxième couche structurelle (32) dans les première et deuxième régions (10a-10b), la deuxième couche structurelle (32) ayant une épaisseur ($e_2$) égale à la différence entre la première dimension critique ($CD_1$) et la deuxième dimension critique ($CD_2$) ;
     ◦ gravure anisotrope (S3-2) de la deuxième couche structurelle (32) ; et
     ◦ retrait (S3-3, S3-4) de la deuxième couche structurelle (32) dans la première région (10b) ;

   - retrait (S4) des premier et deuxième motifs sacrificiels (20a-20b) de manière sélective par rapport aux premiers et deuxièmes espaceurs (41-42).

2. Procédé selon la revendication 1, dans lequel :

   - le premier motif sacrificiel (20a) sépare deux premières cavités (21a) présentant une troisième dimension critique ($CD_3$) ;
   - le deuxième motif sacrificiel (20b) sépare deux deuxièmes cavités (21b) présentant une quatrième dimension critique ($CD_4$) ; et
   - les premiers et deuxièmes espaceurs (41-42) sont formés sur des parois latérales des premières et deuxièmes cavités (21a-21b).

3. Procédé selon la revendication 2, dans lequel la troisième dimension critique ($CD_3$) et la quatrième dimension critique

(CD$_4$) satisfont les relations suivantes :

$$CD_3 = CD_1 + 2 \times e_1$$

$$CD_4 = CD_2 + 2 \times e_1 + 2 \times e_2$$

où CD$_1$ est la première dimension critique, e$_1$ est l'épaisseur de la première couche structurelle (31), CD$_2$ est la deuxième dimension critique et e$_2$ est l'épaisseur de la deuxième couche structurelle (32).

4. Procédé selon l'une quelconque des revendications 1 à 3, dans lequel le dépôt conforme (S3-1) de la deuxième couche structurelle (32) est accompli après la gravure anisotrope (S2-2) de la première couche structurelle (31).

5. Procédé selon l'une quelconque des revendications 1 à 3, dans lequel le dépôt conforme (S3-1) de la deuxième couche structurelle (32) est consécutif au dépôt conforme (S2-1) de la première couche structurelle (31) et dans lequel la gravure anisotrope (S2-2) de la première couche structurelle (31) est consécutive à la gravure anisotrope (S3-2) de la deuxième couche structurelle (32).

6. Procédé selon l'une quelconque des revendications 1 à 5, dans lequel le retrait (S3-3, S3-4) de la deuxième couche structurelle (32) dans la première région (10a) est accompli après la gravure anisotrope (S3-2) de la deuxième couche structurelle (32).

7. Procédé selon l'une quelconque des revendications 1 à 5, dans lequel le retrait (S3-3, S3-4) de la deuxième couche structurelle (32) dans la première région (10a) est accompli avant la gravure anisotrope (S3-2) de la deuxième couche structurelle (32).

8. Procédé selon l'une quelconque des revendications 1 à 7, dans lequel le retrait (S4) des premier et deuxième motifs sacrificiels (20a-20b) est accompli après le retrait (S3-3, S3-4) de la deuxième couche structurelle (32) dans la première région (10a).

9. Procédé selon l'une quelconque des revendications 1 à 6, dans lequel le retrait (S4) des premier et deuxième motifs sacrificiels (20a-20b) est accompli entre la gravure anisotrope (S3-2) de la deuxième couche structurelle et le retrait (S3-3, S3-4) de la deuxième couche structurelle (32) dans la première région (10a).

10. Procédé selon l'une quelconque des revendications 1 à 9, dans lequel le retrait de la deuxième couche structurelle (32) dans la première région (10a) comprend la formation (S3-3) d'un masque de gravure (50) sur la deuxième couche structurelle (32) dans la deuxième région (10b), la gravure (S3-3) de la deuxième couche structurelle (32) à travers le masque de gravure (50), sélectivement par rapport à la première couche sacrificielle (31), et le retrait (S3-4) du masque de gravure (50).

11. Procédé selon l'une quelconque des revendications 1 à 10, dans lequel la différence entre la première dimension critique (CD$_1$) et la deuxième dimension critique (CD$_2$) est supérieure ou égale à 4 nm, de préférence comprise entre 4 nm et 70 nm.

**Fig. 1**

**Fig. 2**

S1-1

22 { 221, 222 }
21
10 { 103, 102, 101 }

S

**Fig. 3A**

S1-2    21a  $CD_1$   20a 21a 21b        $CD_2$ 20b  21b    $(CD_2 < CD_1)$
21                          $CD_3$                     $CD_4$        S
10 {
10a          10b

**Fig. 3B**

S2-1          20a              20b
31                                               $e_1$
21                                               S
10 {
10a          10b

**Fig. 3C**

S2-2          20a              20b
             41  41          41  41
21                                               S
10 {
10a          10b

**Fig. 3D**

S3-1          20a              20b
             41  41          41  41
32                                       $e_2 = CD_1 - CD_2$
21                                               S
10 {
10a          10b

**Fig. 3E**

**Fig. 3F**

**Fig. 3G**

**Fig. 3H**

**Fig. 3I**

**Fig. 4A**

**Fig. 4B**

**Fig. 4C**

**Fig. 4D**

$e_2 = CD_1 - CD_2$

**Fig. 4E**

**Fig. 4F**

**Fig. 4G**

**Fig. 4H**

**Fig. 4I**

Fig. 5A

Fig. 5B

$(CD_2 < CD_1)$

Fig. 5C

Fig. 5D

**S3-3**

31
21
32
50
S
10 {
10a    10b

**Fig. 5E**

**S3-4**

31
21
32
S
10 {
10a    10b

**Fig. 5F**

**S3-2 & S2-2**

21
41
42 41 42 41
S
10 {
10a    10b

**Fig. 5G**

**S4**

CD$_A$
40a/41
40b  40b
41 42  41 42
S
P
CD$_B$
P
103
102
101
10 {
10a    D    10b

**Fig. 5H**

$(CD_5 < CD_2 < CD_1)$

S2-1, S3-1 & S5-1

Fig. 6A

S5-2

Fig. 6B

S3-3

Fig. 6C

S5-3, S3-2 & S2-2

Fig. 6D

Europäisches
Patentamt

European
Patent Office

Office européen
des brevets

**RAPPORT DE RECHERCHE EUROPEENNE**

Numéro de la demande

EP 24 18 1985

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2020/211848 A1 (SHILIANG JI [CN] ET AL) 2 juillet 2020 (2020-07-02) * alinéa [0018] * * alinéa [0032] - alinéa [0037] * * alinéa [0057] - alinéa [0077] * * figures 3, 4, 6-8, 13 * | 1,2,4-11 | INV. H01L21/033 H01L21/311 |
| Y | US 2021/088897 A1 (TIRON RALUCA [FR] ET AL) 25 mars 2021 (2021-03-25) * figure 3E * | 1,2,4-11 | |
| A,D | Y. CHEN ET AL.: "Analysis of process characteristics of self-aligned multiple patterning", MICROELECTRONIC ENGINEERING, vol. 98, 2012, pages 184-188, XP002810641, * le document en entier * | 1-11 | |
| A | US 2021/125836 A1 (HUANG KUAN-WEI [TW] ET AL) 29 avril 2021 (2021-04-29) * alinéa [0033] - alinéa [0042] * * figures 4A-7A * | 1-11 | DOMAINES TECHNIQUES RECHERCHES (IPC) H01L |

Le présent rapport a été établi pour toutes les revendications

| Lieu de la recherche | Date d'achèvement de la recherche | Examinateur |
|---|---|---|
| La Haye | 4 novembre 2024 | Boubal, François |

## ANNEXE AU RAPPORT DE RECHERCHE EUROPEENNE
## RELATIF A LA DEMANDE DE BREVET EUROPEEN NO.

EP 24 18 1985

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-11-2024

| Document brevet cité au rapport de recherche | Date de publication | Membre(s) de la famille de brevet(s) | | Date de publication |
|---|---|---|---|---|
| US 2020211848 A1 | 02-07-2020 | CN | 111370299 A | 03-07-2020 |
| | | US | 10685838 B1 | 16-06-2020 |
| US 2021088897 A1 | 25-03-2021 | EP | 3729491 A1 | 28-10-2020 |
| | | FR | 3075775 A1 | 28-06-2019 |
| | | JP | 2021507297 A | 22-02-2021 |
| | | KR | 20200096981 A | 14-08-2020 |
| | | TW | 201936482 A | 16-09-2019 |
| | | US | 2021088897 A1 | 25-03-2021 |
| | | WO | 2019122334 A1 | 27-06-2019 |
| US 2021125836 A1 | 29-04-2021 | CN | 112750760 A | 04-05-2021 |
| | | KR | 20210053212 A | 11-05-2021 |
| | | US | 2021125836 A1 | 29-04-2021 |

EPO FORM P0460

Pour tout renseignement concernant cette annexe : voir Journal Officiel de l'Office européen des brevets, No.12/82

# EP 4 481 793 A1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Y. CHEN et al.** Analysis of process characteristics of self-aligned multiple patterning. *Microelectronic engineering*, 2012, vol. 98, 184-188